# EUROPEAN PATENT APPLICATION

(11) **EP 4 456 132 A1**
(43) Date of publication of application: **30.10.2024**
(21) Application number: 24171773.5
(22) Date of filing: 23.04.2024
(51) Int. Cl.: H01L 23/64, H01L 23/31, H01L 25/07, H01L 23/48

(54) **SEMICONDUCTOR PACKAGE, METHOD OF FORMING SEMICONDUCTOR PACKAGE, AND POWER MODULE**

(30) Priority: 28.04.2023 CN 202310489424; 28.04.2023 CN 202321027620 U
(71) Applicant: Shenzhen STS Microelectronics Co., Ltd., Shenzhen 518048 (CN); STMicroelectronics International N.V., 1228 Plan-les-Ouates, Geneva (CH)
(72) Inventor: LIU, Qian, SHENZHEN, 518038 (CN); TIZIANI, Roberto, 20014 NERVIANO (IT)
(74) Representative: Cabinet Beaumont

(57) **Abstract**

Embodiments of the present disclosure relate to a semiconductor package, a method of forming semiconductor package and a power module. For example, there is provided a semiconductor package. The semiconductor package may comprise a chip level having a first side and a second side opposite to the first side, wherein the chip level comprises a plurality of power transistors and each power transistor is provided with a source and a gate at the first side. Besides, the semiconductor package may also comprise a first conductive level positioned on the first side and comprising a gate connection portion electrically connected with the gate and a source connection portion electrically connected with the source. The semiconductor package further comprises a second conductive level comprising a gate lead-out portion electrically connected with the gate connection portion and a source lead-out portion electrically connected with the source connection portion, wherein the first conductive level is positioned between the second conductive level and the chip level. Embodiments of the present disclosure may enhance the working performance of the product by improving consistency of conductive paths from the gate and the source of each power transistor to corresponding points.

## Description

### FIELD

Embodiments of the present disclosure generally relate to the field of semiconductors, and more specifically, to a semiconductor package, a method of forming semiconductor package, and a power module.

### BACKGROUND

A power module refers to a module formed by combining and connecting power transistors according to certain functions. Depending on the application fields, the power module may implement frequency conversion, amplification, voltage stabilization, rectification, and inversion functions and the like. For the power module including a plurality of power transistors (two or more) connected in parallel, the source of respective power transistor is required to be uniformly connected to a KS signal terminal of the module and then to a drive plate. Besides, there is only one KS signal terminal. The gate of respective power transistor is required to be uniformly connected to a gate signal terminal of the module and then to the drive plate. Further, there is only one gate signal terminal. The KS signal is a signal read by the drive plate and the gate signal is a control signal transmitted by the drive plate. The ON and OFF of each power transistor is determined through a voltage difference between the gate and the KS. With the miniaturization trend of the power module and restrictions of existing package manufacturing process, in the power module consisting of a plurality of power transistors in parallel, the electrode (source or gate) of respective power transistor may first electrically connect to a substrate via a lead or copper clip and then electrically connect to a signal terminal of the module through the substrate. Since the physical path from the electrode (source or gate) of respective power transistor to the corresponding signal terminal of module detection is different, the signals read and/or transmitted by the drive plate are inaccurate, resulting into poor performance of switch control of the power module.

### SUMMARY

In accordance with example embodiments of the present disclosure, there is provided a new semiconductor package solution.

In a first aspect of the present disclosure, there is provided a semiconductor package. The semiconductor package comprises a chip level having a first side and a second side opposite to the first side, wherein the chip level comprises a plurality of power transistors and each power transistor is provided with a source and a gate at the first side. Besides, the semiconductor package may also comprise a first conductive level positioned on the first side and comprising a gate connection portion electrically connected with the gate and a source connection portion electrically connected with the source. The semiconductor package further comprises a second conductive level comprising a gate lead-out portion electrically connected with the gate connection portion and a source lead-out portion electrically connected with the source connection portion, wherein the first conductive level is positioned between the second conductive level and the chip level.

In a second aspect of the present disclosure, there is provided a method of forming a semiconductor package. The method may comprise: forming a chip level having a first side and a second side opposite to the first side and comprising a plurality of power transistors, where each power transistor is provided with a source and a gate at the first side; forming, on the first side of the chip level, a first conductive level, the first conductive level comprising a gate connection portion electrically connected with the gate and a source connection portion electrically connected with the source; and forming, on a side of the first conductive level away from the chip level, a second conductive level, the second conductive level comprising a gate lead-out portion electrically connected with the gate connection portion and a source lead-out portion electrically connected with the source connection portion.

In a third aspect of the present disclosure, there is provided a power module, comprising: a substrate at least arranged with a gate wiring board and a source wiring board; and the semiconductor package described according to the first aspect of the present disclosure, wherein the semiconductor package is positioned on the substrate, and the gate lead-out portion is electrically connected to the gate wiring board via a gate line and the source lead-out portion is electrically connected to the source wiring board via a source line.

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter. Other features of the present disclosure will be understood more easily through the following description.

### BRIEF DESCRIPTION OF THE DRAWINGS

With reference to the drawings and the following detailed description, the above and other features, advantages and aspects of various embodiments of the present disclosure will become more apparent. In the drawings, same or similar reference signs indicate same or similar elements, wherein:
Fig. 1 illustrates a schematic diagram of a conventional power module containing a plurality of power transistors;
Fig. 2A illustrates an exploded diagram of a semiconductor package in accordance with embodiments of the present disclosure and Fig. 2B illustrates a schematic diagram of an assembled semiconductor package in accordance with embodiments of the present disclosure;
Fig. 3 illustrates a side section of a structure of a single power transistor in the semiconductor package in accordance with embodiments of the present disclosure;
Fig. 4 illustrates a schematic diagram of an arrangement of a plurality of power transistors and the gate connection portion of the first conductive level in the semiconductor package in accordance with embodiments of the present disclosure;
Fig. 5 illustrates a flowchart of a procedure of forming the semiconductor package in accordance with embodiments of the present disclosure;
Figs. 6A to 6D illustrate schematic diagrams of each phase of the formation of the semiconductor package in accordance with embodiments of the present disclosure;
Fig. 7A illustrates a schematic diagram of a power module containing the semiconductor package in accordance with embodiments of the present disclosure and Fig. 7B demonstrates an equivalent circuit diagram of the power module;
Fig. 8A illustrates an exploded view of a power module containing the semiconductor package in accordance with a further embodiment of the present disclosure, Fig. 8B illustrates a top view of the power module in this embodiment, and Fig. 8C illustrates an equivalent circuit diagram of the power module;
Fig. 9A illustrates an exploded view of a power module containing the semiconductor package in accordance with another embodiment of the present disclosure, Fig. 9B illustrates a top view of the power module in this embodiment, and Fig. 9C illustrates an equivalent circuit diagram of the power module; and
Fig. 10A illustrates a schematic diagram of a power module containing the semiconductor package in accordance with a further embodiment of the present disclosure, Fig. 10B is a schematic diagram of a front portion of the semiconductor package, Fig. 10C is a schematic diagram of back portion of the semiconductor package, and Fig. 10D illustrates an equivalent circuit diagram of the power module.

### DETAILED DESCRIPTION OF EMBODIMENTS

Embodiments of the present disclosure will be described in more details below with reference to the drawings. Although some embodiments of the present disclosure are demonstrated in the drawings, it should be understood that the present disclosure can be implemented by various manners and should not be limited to the embodiments explained herein. On the contrary, the embodiments are provided for a more thorough and complete understanding of the present disclosure. It should be understood that the drawings of the present disclosure and their embodiments are only exemplary and shall not restrict the protection scope of the present disclosure.

Throughout the description of the embodiments of the present disclosure, the term "comprises" and its variants are to be read as open-ended terms that mean "comprises, but is not limited to." The term "based on" is to be read as "based at least in part on." The term "one embodiment" or "this embodiment" is to be read as "at least one embodiment." The terms "first", "second" and so on can refer to same or different objects. The following text can comprise other explicit and implicit definitions.

The direction terms (such as "top", "bottom", "over", "under", "front", "back", "head", "tail", "above" and "below" etc.) may be used with reference to the directions of the described drawings and/or elements. Since embodiments may be positioned in various directions, the direction terms are provided for explanatory purpose, rather than restrictive. In some embodiments, the above direction terms may be substituted with equivalent direction terms based on the orientations of the embodiments as long as the general directional relation between the elements and the general purpose thereof are maintained.

In the present disclosure, expressions including serial numbers (such as "first", "second", etc.) can modify various elements. However, the elements may not be restricted to the above expressions. For example, the above expressions do not limit sequence and/or importance of the elements. The above expressions are provided merely for distinguishing one element from another.

It is to be understood that when one element is "connected" or "coupled" to a further element, it may be directly connected or coupled to the further element, or an intermediate element may be provided therebetween. On the contrary, when one element is known to be "directly connected" or "directly coupled" to the further element, no intermediate elements are present. Other expressions describing the relation between elements may be interpreted in similar ways (such as "between" and "directly between", and "adjacent" and "directly adjacent" etc.).

In the embodiments described herein or illustrated by the drawings, any direct electrical connections or coupling (i.e., any connections or coupling without additional intermediate elements) also may be implemented by indirect connections or coupling (i.e., connections or coupling with one or more intermediate elements) and vice versa as long as the general purpose of connection or coupling is basically maintained.

As described above, to connect a source of each power transistor to a drive circuit, a module KS detection point is usually disposed in a neighboring area of a plurality of power transistors. Kelvin Source (KS) voltage may be detected via the detection point. However, the conductive path from the source of each power transistor to the detection point may vary and different conductive paths may lead to distinct electrical parameters, such as parasitic capacitance and parasitic inductance from different sources to the module detection point. In such case, KS voltage values detected during turn-on and turn-off process of the power transistor differ from the actual source voltage values of respective power transistors. Correspondingly, to connect the gate of each power transistor to the drive circuit, a module gate detection point is usually disposed in a neighboring area of a plurality of power transistors. However, a conductive path from the gate of each power transistor to the detection point may vary and different conductive paths may lead to distinct electrical parameters, such as parasitic capacitance and parasitic inductance from different gates to the module gate detection point. In such case, waveforms of gate control signals from the drive module to respective parallel power transistors may differ. Accordingly, traditional solutions lower reliability of the power module.

As described above, the conductive path from the source of a plurality of power transistors to the detection point may vary in the traditional power module. However, the differences in electrical characteristics resulted from various conductive paths may produce a relatively large error between the detected KS value and the actual value of at least a part of the power transistors in the power module. Because of this error, the control signal transmitted from the drive module does not match with the actual KS value of part of the power transistors, which further lower reliability of the power module.

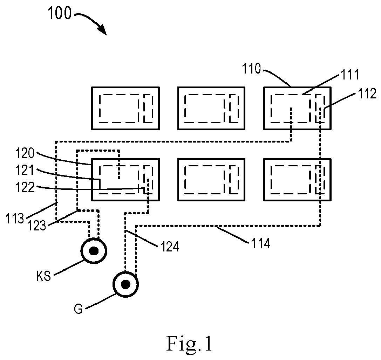

Specifically, Fig. 1 illustrates a schematic diagram of a conventional power module 100 containing a plurality of power transistors. In Fig. 1, the power module 100 consists of a plurality of power transistors, and the power transistors at least comprise a power transistor 110 and a power transistor 120. To electrically connect with the drive module, the power module 100 is also arranged with a module gate detection point G and a module KS detection point. As shown in Fig. 1, a conductive path 113 from a source 111 of the power transistor 110 to the module KS detection point is different from a conductive path 123 from a source 121 of the power transistor 120 to the module KS detection point. It is to be understood that the conductive paths 113 and 123 shown in Fig. 1 are not the paths which electrical signals actually pass, which may be appreciated as equivalent paths obtained by simulation for simplification purpose. Correspondingly, a conductive path 114 from a gate 112 of the power transistor 110 to the module gate detection point G is different from a conductive path 124 from a gate 122 of the power transistor 120 to the module gate detection point G.

For a switch control implemented by a plurality of power transistors in parallel, on account of the different conductive paths from the source of each power transistor to the module KS detection point, parasitic capacitance and parasitic inductance, among other electrical parameters, from the sources of respective power transistors to the module KS detection point may differ, such that the KS voltage values detected during turn-on and turn-off process of the power transistor vary from the actual source voltage values of the respective power transistors, i.e., the KS voltage values measured by the module could not accurately reflect instantaneous source voltage values of each power transistor. Similarly, because of the different conductive paths from the gate of each power transistor to the module gate detection point, parasitic capacitance and parasitic inductance, among other electrical parameters, from the gates of respective power transistors to the module gate detection point may differ. When the drive circuit generates a gate control signal based on the measured KS voltage values, waveforms of gate control signals from the drive module to respective parallel power transistors may differ. Due to the above superimposed errors, the switch control of parallel power transistors deviates from the theoretical setting of the drive module, and the greater the superposition error is, the greater the deviation becomes. In the end, the performance of the switch control of the parallel power transistors, i.e., switch control consistency and parallel chip dynamic current sharing etc., is not ideal.

In accordance with embodiments of the present disclosure, there is provided a new semiconductor package solution. Accordingly, each power transistor in the power module is such packaged that a distance from the gate to the module gate detection point G is consistent and a distance from the source to the module KS detection point is almost consistent, thereby solving the above and/or other potential problems. Various embodiments of the present disclosure are to be described in details below with reference to the above example scenarios. It is to be understood that this is only for the purpose of explanation and is not intended to restrict the scope of the present invention in any ways.

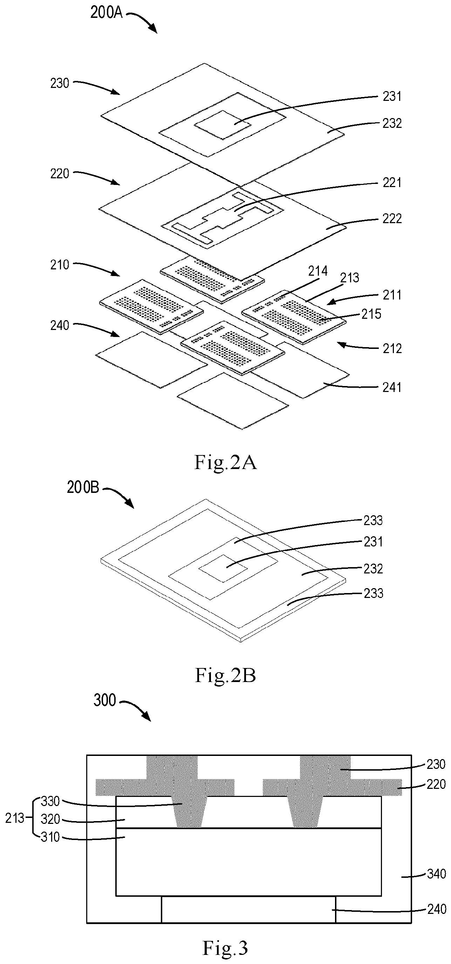

Fig. 2A illustrates an exploded diagram of a semiconductor package 200A in accordance with embodiments of the present disclosure and Fig. 2B illustrates a schematic diagram of an assembled semiconductor package 200B in accordance with embodiments of the present disclosure. It is to be understood that the semiconductor packages 200A and 200B demonstrated in Figs. 2A and 2B are merely examples in which the embodiments of the present disclosure can be implemented and are not intended to restrict the scope of the present disclosure.

As shown in Fig. 2A, the semiconductor package 200Amay comprise a chip level 210 having, in Fig. 2A, a first side 211 and a second side 212 opposite to the first side 211. It should be appreciated that the chip level 210 shown in Fig. 2A is provided with four power transistors and each of the power transistors is arranged with gate and source electrodes at the first side 211. It is to be appreciated that a region where the source is positioned may have a larger area. For example, the area may be greater than that of a region where the gate is positioned. As an example, a power transistor 213 in the chip level 210 is provided with a gate 214 and a source 215 at the side 211. Besides, those skilled in the art may understand that the power transistor 213 is also provided with a drain at the side 212 although not illustrated. It is to be appreciated that although Fig. 2A demonstrates four power transistors, other numbers of power transistors may also be provided in the chip level 120.

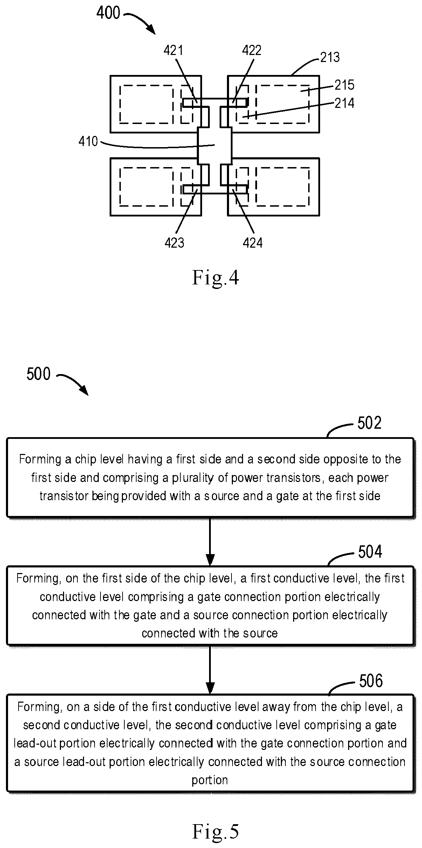

Moreover, the semiconductor package 200A also may comprise a first conductive level 220 provided on the first side 211 of the chip level 210. According to Fig. 2A, the first conductive level 220 may include a gate connection portion 221 electrically connected to a gate of the power transistor (e.g., gate 214 of the power transistor 213) in the chip level 210 and a source connection portion 222 electrically connected to a source of the power transistor (such as source 215 of the power transistor 213). The source connection portion 222 may be designed with a larger area. For example, the area may be greater than or equal to a sum of areas of the sources of the power transistors in the chip level 210. It is to be understood that the source connection portion 222 having a larger area may help minimize differences in the conductive paths from the sources of respective power transistors to the module KS detection point. The detailed description of the gate connection portion 221 may refer to the following text with reference to Fig. 4.

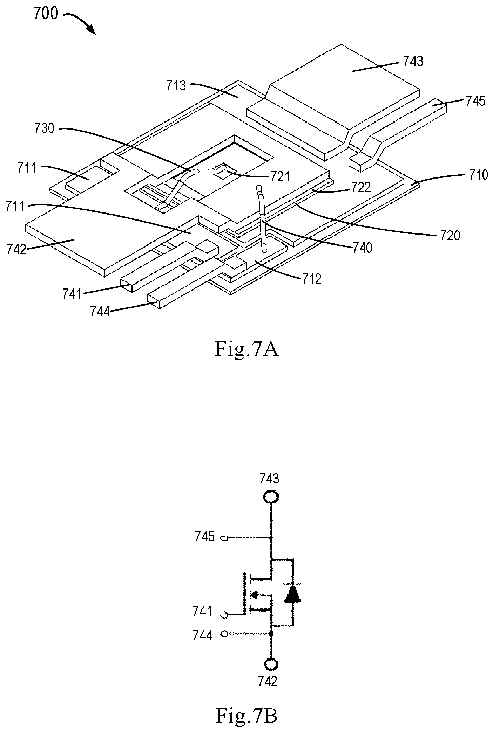

The semiconductor package 200A may further comprise a second conductive level 230, which is disposed on the first conductive level 220. In other words, the first conductive level 220 is positioned between the second conductive level 230 and the chip level 210. As shown in Fig. 2A, the second conductive level 230 may comprise a gate lead-out portion 231 electrically connected with the gate connection portion 221 and a source lead-out portion 232 electrically connected with the source connection portion 222. Both the gate lead-out portion 23 1 and the source lead-out portion 232 are electrical connectors of the semiconductor package 220 with external circuits. Specific forms of the connection will be described in details below with reference to Fig. 7A.

It is to be appreciated that the first conductive level 220 and the second conductive level 230 both may be made of electrically conductive metals such as copper, silver and the like, to implement satisfactory conductive performance.

Moreover, the semiconductor package 200A also may comprise a heat sink level 240 disposed below the chip level 210. In other words, the chip level 210 is positioned between the heat sink level 240 and the first conductive level 220. According to Fig. 2A, the heat sink level 240 may comprise four heat sinks and each heat sink contacts respective power transistors of the plurality of power transistors in the chip level 210. For example, the heat sink 241 is in contact with the power tube 213 above it.

Through the above embodiments, the gates of respective power transistors in the chip level 210 each may be connected to the module gate detection point G through the gate connection portion 221 and the gate lead-out portion 231. In addition, the sources of respective power transistors in the chip level 210 each may be connected to the module KS detection point through the source connection portion 222 and the source lead-out portion 232.

Moreover, as shown in Fig. 2B, the chip level 210, the first conductive level 220, the second conductive level 230 and the heat sink level 240 may be combined into the semiconductor package 200B. As shown in Fig. 2B, the semiconductor package 200B may comprise exposed gate lead-out portion 231 and source lead-out portion 232, whereas the rest of the upper surface of the semiconductor package 200B may be configured as an electrically insulated plastic package portion 233.

To more clearly demonstrate the main structure of each power transistor in the semiconductor packages 200A and 200B, Fig. 3 illustrates a side section of a structure 300 of a single power transistor in the semiconductor package in accordance with embodiments of the present disclosure. As shown in Fig. 3, the structure 300 may comprise the power transistor 213, the first conductive level 220, the second conductive level 230, the heat sink portion 240 and a plastic package portion 340. It is to be understood that the first conductive level 220 and the second conductive level 230 illustrated in Fig. 3 in fact are just a portion of the entire level.

In Fig. 3, the power transistor 213 may comprise a power transistor body 310. It is to be appreciated that a source region and a gate region are formed at an upper side of the power transistor body 310 although not illustrated in Fig. 3. The source region corresponds to the source 215 in Fig. 2A and the gate region corresponds to the gate 214 in Fig. 2A. Furthermore, the power transistor 213 comprises an insulating layer 320 disposed over the power transistor body 310. As shown in Fig. 3, a plurality of through holes is formed on the source region and the gate region. Besides, conductive pieces 330, for example made of copper, are filled in the through holes, such that the source region of the power transistor body 310 is electrically connected to the gate connection portion of the first conductive level 220, and the gate region of the power transistor body 310 is electrically connected to the source connection portion of the first conductive level 220. Moreover, the second conductive level 230 may be formed on the first conductive level 220, so as to form corresponding gate lead-out portion and source lead-out portion.

Fig. 4 illustrates a schematic diagram of an arrangement 400 of a plurality of power transistors and the gate connection portion of the first conductive level in the semiconductor package in accordance with embodiments of the present disclosure. As shown, in the arrangement 400, the gate connection portion may be disposed at the geometric center of the four power transistors. Specifically, in Fig. 4, the gate connection portion may comprise a connection body 410 and connection branches 421, 422, 423 and 424 and each of the power transistors (such as power transistor 213) may comprise the gate 214 and the source 215. The connection body 410 is arranged at the geometric center of the power transistors, and although not illustrated, the gate lead-out portion may be disposed above the connection body 410. In addition, each of the connection branches 421, 422, 423 and 424 may have one end connected to the connection body 410 and the other end is connected to the gates of the corresponding power transistors in these power transistors. As an example, the connection branch 422 in Fig. 4 may be configured to connect with the gate 214 of the power transistor 213. Through the above embodiments, the gates of these power transistors may all be connected to the module gate detection point G via the gate connection portion consisting of the connection beaches and the connection body and the corresponding gate lead-out portion. The gates of the respective power transistors follow the same conductive path towards the module gate detection point G. Therefore, parasitic capacitance and parasitic inductance among other electrical parameters from the gates of the respective power transistors to the module gate detection point G are made consistent, which makes it easy to strictly unify the switching moves of the power transistors at temporal level.

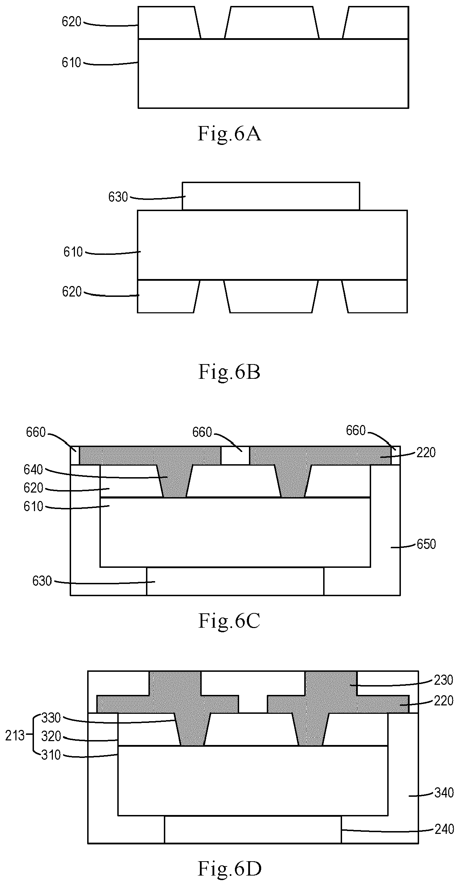

The above described technical solution is merely an example, rather than a restriction over the present invention. It is to be understood that the entire semiconductor package also may be arranged in accordance with other ways and connections. To more clearly explain the principle of the above solution, the process of forming the above semiconductor package of the present disclosure is to be described in more details below with reference to Fig. 5. Further, each phase of the formation of the semiconductor package is to be described in details below with reference to Figs. 6A-6D.

Fig. 5 illustrates a flowchart of a procedure 500 of forming the semiconductor package in accordance with embodiments of the present disclosure. Figs. 6A to 6D illustrate schematic diagrams of each phase of the formation of the semiconductor package in accordance with embodiments of the present disclosure. For the sake of understanding, the specific instances mentioned in the following description are exemplary and shall not restrict the protection scope of the present disclosure.

At block 502, the chip level 210 is formed, which chip level 210 has a first side 211 and a second side 212 opposite to the first side 211 in Fig. 2A. It should be appreciated that the chip level 210 shown in Fig. 2A is provided with four power transistors and each of the power transistors is arranged with gate and source electrodes at the first side 211. It is to be appreciated that a region where the source is positioned may have a larger area. For example, the area may be greater than that of a region where the gate is positioned.

Specifically, as shown in Fig. 6A, to form the chip level 210, a power transistor body 610 at least having the gate region and the source region may be formed. As an example, a wafer on which a plurality of power transistor bodies is arranged may be formed. It should be appreciated that the detailed position of the gate region and the source region of the power transistor body 610 may be determined with reference to Fig. 2A and will not be repeated below.

Afterwards, an insulating layer 620 may be formed at an upper side of the wafer containing the power transistor body 610, and the insulating layer 620 may be implemented as an ABF carrier plate. Further, a plurality of through holes respectively corresponding to the gate region and the source region may be formed in the insulating layer 620. As an example, the through holes may be formed at designated positions of the insulating layer 620 through laser boring, plasma etching and grinding processes etc., so as to form a plurality of unfinished power transistors through wafer dicing.

Furthermore, as shown in Fig. 6B, a heat sink 630 in the heat sink level may be formed on a second side of each unfinished power transistors in the chip level by flipping the unfinished power transistors. As shown in Fig. 2A, the heat sink level 240 may comprise four heat sinks, each of which four heat sinks makes contact with respective power transistors in the plurality of power transistors of the chip level 210. Specifically, the second side of the chip level may be sputtered using TiCu. Since the heat sink as metal may have a poor connection with the chip level, the connectivity performance may be enhanced by sputtering a TiCu layer on the chip level. Then, a corresponding heat sink, e.g., heat sink 630, is formed at a predetermined position of the second side of the sputtered chip level. It should be appreciated that the TiCu layer for sputtering purpose and other material layers for formation of the heat sink may all be removed by one or more existing etching or cleaning processes in the art.

Moreover, as shown in Fig. 6C, a plastic package portion 650 may be formed around the heat sink 630. It is to be understood that the plastic package portion 650 may be formed at the same layer with the heat sink 630 and the heat sink 630 is exposed. Besides, the plastic package portion on the same layer with the power transistor body 610 and the insulating layer 620 may be formed during the formation of the power transistor body 610 and the insulating layer 620, and the plastic package portion on the same layer with the heat sink 630 may be formed during the formation of the heat sink 630. However, the two plastic package portions may be made of different materials.

Next, conductive pieces 640 may be filled in the plurality of through holes by flipping the formed components. As shown in Fig. 3C, the gate region of the power transistor body 610 may be electrically connected to the gate connection portion of the first conductive level 220, and the source region of the power transistor body 610 may be electrically connected to the source connection portion of the first conductive layer 220.

In some embodiments, to fill the conductive pieces 640 in a plurality of through holes, the through holes may be sputtered with TiCu, so as to enhance connectivity performance among the conductive pieces 640, the first conductive level 220 and other layers by sputtering a TiCu layer. Further, the conductive pieces 640 may be filled into a plurality of sputtered through holes and the TiCu layer may be removed by etching. It is to be understood that the TiCu layer for sputtering purpose and other material layers for formation of the heat sink may all be removed by one or more existing etching or cleaning processes in the art.

At block 504, the first conductive level 220 also may be formed on the first side of the chip level 210. In some embodiments, the first conductive level 220 may be formed together with the conductive pieces 640 through configuring a patterning layer 660 as shown in Fig. 3C. Accordingly, similar to the example of the sputtering process implemented before the formation of the conducive pieces 640, prior to one-step formation of the conductive pieces 640 and the first conductive level 220 through configuring the patterning layer 660, sputtering may be performed on the through holes and the exposed portion of the patterning layer 660, thereby enhancing connectivity performance among the conductive pieces 640, the first conductive level 220 and other layers by sputtering a TiCu layer. After the conductive pieces 640 are filled into the plurality of sputtered through holes and the first conductive level 220 is formed on the exposed portion of the patterning layer 660, the TiCu layer is removed by etching. In addition, laser may be applied, for example to a resin molded side of the chip level, to deform the material at the irradiated site and further form the first conductive level (e.g., copper plating) at the deformed site. Since the deformed material has an increased contact area with the first conductive level, the connectivity performance is enhanced.

In some embodiments, as shown in Figs. 2A and 4, to implement consistency of conductive paths, the gate connection portion 221 of the first conductive level 220 may be formed to comprise the connection body 410 and the connection branches 421, 422, 423 and 424. The connection body 410 is arranged at the geometric center of a plurality of power transistors of the chip level 210. In addition, each of the connection branches 421, 422, 423 and 424 may have one end connected to the connection body 410 and the other end is connected to the gates of the corresponding power transistors in these power transistors.

At block 506, as shown in Fig. 6D, the second conductive level 230 may be formed at a side of the first conductive level 220 away from the chip level 210. As shown in Fig. 2A, the second conductive level 230 may comprise the gate lead-out portion 231 electrically connected with the gate connection portion 221 of the first conductive level 220 and the source lead-out portion 232 electrically connected with the source connection portion 222 of the first conductive level 220.

It should be appreciated that the above procedure may be completed in order according to any reasonable sequences or in parallel.

It also should be understood that semiconductor package manufactured through the above process may be applied, for example, to power modules of electronic control units of automotive systems. In some embodiments, the power module may comprise at least one of the semiconductor packages described in the above multiple embodiments and combinations thereof.

Fig. 7A illustrates a schematic diagram of a power module 700 containing the semiconductor package in accordance with embodiments of the present disclosure and Fig. 7B demonstrates an equivalent circuit diagram of the power module 700. As shown in Fig. 7A, the power module 700 may comprise a substrate 710 and a semiconductor package 720 manufactured following the above process. In Fig. 7A, the substrate 710 may comprise a gate wiring board 711, a source wiring board 712 and a drain wiring board 713.

As stated above, the gates of each of a plurality of power transistors of the semiconductor package 720 are electrically connected to the gate connection portion (not shown in Fig. 7A; see the gate connection portion 221 in Fig. 2A for reference) in the first conductive level of the semiconductor package 720, and the gate connection portion is electrically connected with the gate lead-out portion 721. Further, as shown in Fig. 7A, the gate lead-out portion 721 in the power module 700 is electrically connected to the gate wiring board 711 via a gate line 730 and the gate wiring board 711 is electrically connected with a gate portion 741 of a lead frame.

In other words, the gates of each of a plurality of power transistors of the semiconductor package 720 are electrically connected to the gate portion 741 of the lead frame via the gate connection portion (not shown in Fig. 7A; see the gate connection portion 221 in Fig. 2A for reference) of the first conductive level, the gate lead-out portion 721 of the second conductive level, the gate line 730 and the gate wiring board 711 in the semiconductor package 720. It is to be understood that the gate portion 741 is electrically connected with the module gate detection point G connected to the drive module. Therefore, the conductive paths from the gates of each power transistors to the module gate detection point G in the semiconductor package 720 are substantially the same.

In a further aspect, as stated above, the sources of each of a plurality of power transistors of the semiconductor package 720 are electrically connected to the source connection portion (not shown in Fig. 7A; see the source connection portion 222 in Fig. 2A for reference) in the first conductive level of the semiconductor package 720, and the source connection portion is electrically connected with the source lead-out portion 722. Further, as shown in Fig. 7A, the source lead-out portion 722 in the power module 700 is electrically connected to the source wiring board 712 via a source line 740 and the source wiring board 712 is electrically connected with a source portion 744 of the lead frame.

In other words, the sources of each of a plurality of power transistors of the semiconductor package 720 are electrically connected to the source portion 744 of the lead frame via the source connection portion (not shown in Fig. 7A; see the source connection portion 222 in Fig. 2A for reference) of the first conductive level, the source lead-out portion 722 of the second conductive level, the source line 740 and the source wiring board 712 in the semiconductor package 720. It is to be understood that the source portion 744 is electrically connected with the module KS detection point connected to the drive module. Since both the source connection portion 222 and the source lead-out portion 722 are designed to have a larger area and a greater thickness and the conductive paths from the sources of each power transistor to the module KS detection point in the semiconductor package 720 are substantially the same, differences in conductive paths from the sources of respective power transistors to the module KS detection point are minimized.

It should be appreciated that, as shown in Fig. 7B, the power module 700 is a single switching power module having four power transistors in parallel. It is to be understood that other types of power modules may also be implemented using the semiconductor package provided by the present disclosure.

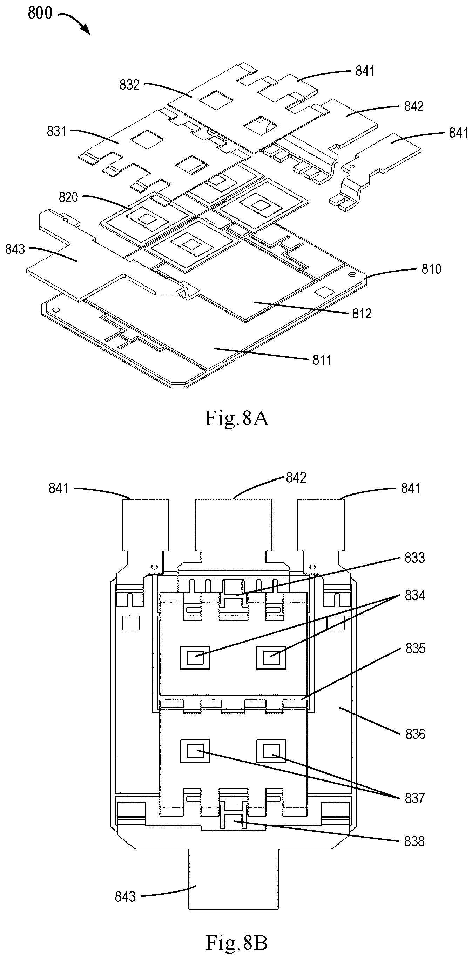

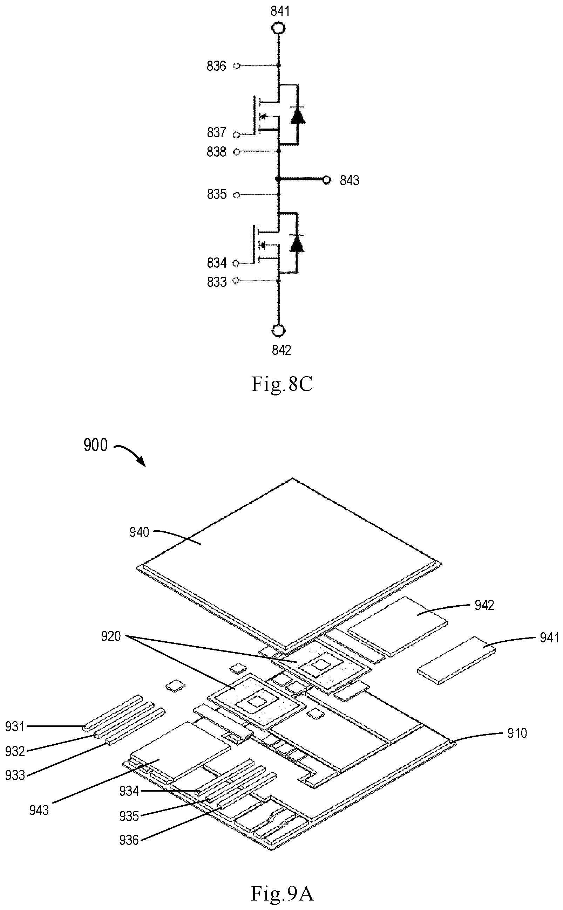

Fig. 8A illustrates an exploded view of a power module 800 containing the semiconductor package in accordance with a further embodiment of the present disclosure, Fig. 8B illustrates a top view of the power module in this embodiment, and Fig. 8C illustrates an equivalent circuit diagram of the power module. In this embodiment, the power module 800 is a half-bridge power module implemented by four semiconductor packages provided by the present disclosure, where two of the semiconductor packages are provided for implementing an upper bridge circuit and the other two are provided for implementing a lower bridge circuit. In addition, each semiconductor package may utilize its gate lead-out portion and source lead-out portion to connect to corresponding points of the half-bridge power module.

As shown in Fig. 8A, the power module 800 may comprise a substrate 810 and a semiconductor package 820 manufactured according to the above process. In Fig. 8A, the substrate may comprise a drain connecting plate 811 for the upper bridge circuit and a drain connecting plate 812 for the lower bridge circuit. The four semiconductor packages 820 are arranged on the substrate 810, such that drains of two semiconductor packages (equivalent to the aforementioned heat sink exposed from the back of the semiconductor package) electrically contact the drain connecting plate 811 for the upper bridge circuit and drains of the other two semiconductor packages electrically contact the drain connecting plate 812 for the lower bridge circuit.

An upper part of the semiconductor package 820 is further provided with a conductive clip 831 for the upper bridge circuit and a conductive clip 832 for the lower bridge circuit. According to Fig. 8A, the conductive clip 831 and the conductive clip 832 are both provided with openings thereon for exposing the gate lead-out portion of each semiconductor package 820. Besides, both the conductive clip 831 and the conductive clip 832 are shaped to electrically contact the source lead-out portion of respective semiconductor packages 820. It is to be noted that at least one side of the conductive clip 831 is arranged with a step to electrically connect with the drain connecting plate 812 for the lower bridge circuit.

As shown in Figs. 8B and 8C, the drain of the semiconductor package for the upper bridge circuit is connected via a drain point 836 to a DC positive input (hereinafter indicated as DC+) of the half-bridge power module. Two gates are both electrically connected to the module gate detection point G via a gate point 837 and corresponding gate lines, and two sources are both connected via a source point 838 to an AC output (hereinafter indicated as AC) point 843 of the half-bridge power module. Correspondingly, the source of the semiconductor package for the lower bridge circuit is connected via a source point 833 to a DC negative input (hereinafter indicated as DC-) point 842 of the half-bridge power module. Two gates are both electrically connected to the module gate detection point G via a gate point 834 and corresponding gate lines, and two drains are both connected via a drain point 835 to an AC point 843 of the half-bridge power module. It should be appreciated that a step of the above conductive clip 831 enables the source point 838 to electrically connect with the drain point 835.

Through the above embodiments, the half-bridge power module may be assembled using a plurality of semiconductor packages according to the present disclosure, the conductive path of the source of each power transistor is made to have substantially the same length, and the conductive path of the gate of each power transistor is made to have substantially the same length. Therefore, signals read and/or transmitted by a driving plate are more accurate, so as to improve switch control of the power module.

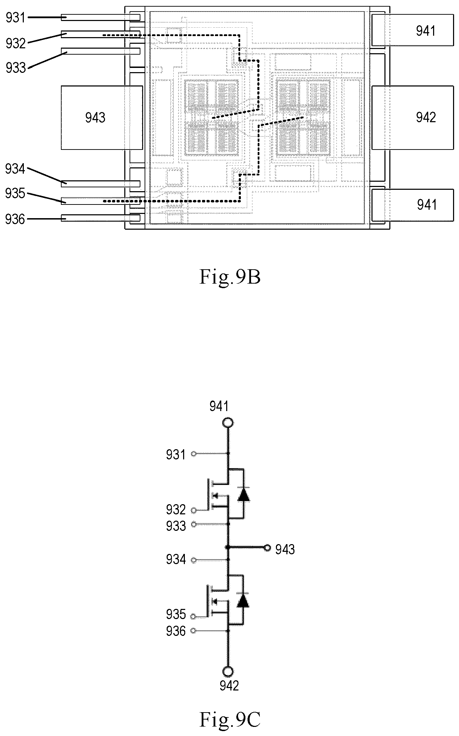

Fig. 9A illustrates an exploded view of a power module 900 containing the semiconductor package in accordance with another embodiment of the present disclosure, Fig. 9B illustrates a top view of the power module in this embodiment, and Fig. 9C illustrates an equivalent circuit diagram of the power module. In this embodiment, the power module 900 is a half-bridge power module implemented by two of the semiconductor packages provided by the present disclosure, where the two semiconductor packages implement an upper bridge circuit and a lower bridge circuit respectively. In addition, each semiconductor package may utilize its gate lead-out portion and source lead-out portion to connect to corresponding points of the half-bridge power module.

As shown in Fig. 9A, the power module 900 may comprise a substrate 910 and a semiconductor package 920 manufactured according to the above process. In Fig. 9A, the substrate 910 may comprise a drain connecting plate for the upper bridge circuit and a drain connecting plate for the lower bridge circuit, similarly as in Fig. 8A. The two semiconductor packages 920 are arranged on the substrate 910, such that the drain of one semiconductor package electrically contacts the drain connecting plate for the upper bridge circuit and the drain of the other semiconductor package electrically contacts the drain connecting plate for the lower bridge circuit.

An upper part of the semiconductor package 920 is further provided with an etched or half-etched substrate 940. On a side of the substrate 940 facing the semiconductor package 920, customized conductive paths are formed respectively for electrically connecting the gate of one semiconductor package to a gate point 932 for the upper bridge circuit, and electrically connecting the gate of the other semiconductor package to a gate point 935 for the lower bridge circuit, and respectively for electrically connecting the source of one semiconductor package to a source point 933 for the upper bridge circuit and electrically connecting the source of the other semiconductor package to a source point 936 for the lower bridge circuit.

As shown in Figs. 9B and 9C, the drain of the semiconductor package for the upper bridge circuit is connected to a DC+ point 941 of the half-bridge power module via a drain point 931, the gate is electrically connected to the module gate detection point G via a gate point 932 and corresponding gate lines, and the source is connected to an AC point 943 of the half-bridge power module via a source point 933. Correspondingly, the source of the semiconductor package for the lower bridge circuit is connected to a DC- point 942 of the half-bridge power module via a source point 936, the gate is electrically connected to the module gate detection point G via a gate point 935 and corresponding gate lines, and the drain is connected to an AC point 943 of the half-bridge power module via a drain point 934.

Through the above embodiments, the half-bridge power module may be assembled using a plurality of semiconductor packages according to the present disclosure, the conductive path of the source of each power transistor is made to have substantially the same length, and the conductive path (e.g., path denoted by dotted line in Fig. 9B) of the gate of each power transistor is made to have substantially the same length. Therefore, crosstalk or other problems resulted from different electrical parameters may be avoided as much as possible. Besides, the above embodiments may achieve double-sided cooling with substrates at both sides.

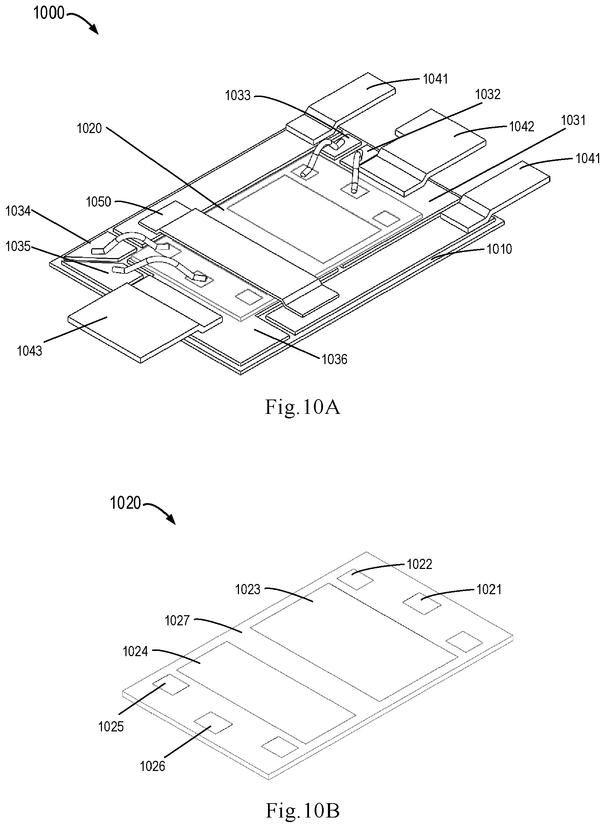

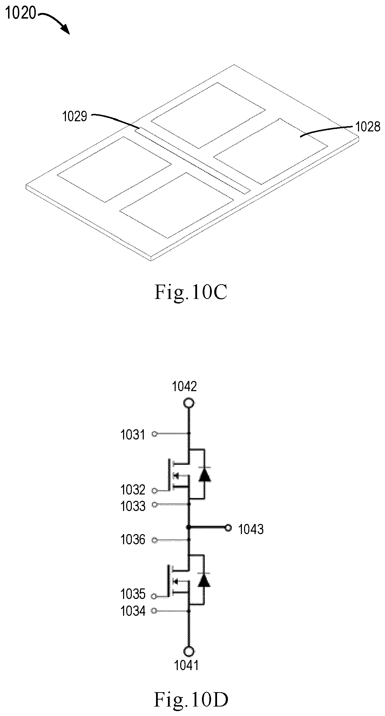

Fig. 10A illustrates a schematic diagram of a power module 1000 containing the semiconductor package in accordance with a further embodiment of the present disclosure, Fig. 10B is a schematic diagram of a front portion of the semiconductor package, Fig. 10C is a schematic diagram showing back of the semiconductor package, and Fig. 10D illustrates an equivalent circuit diagram of the power module. In this embodiment, the power module 1000 utilizes four power transistors in the semiconductor package to implement the half-bridge power module, where two of the power transistors are provided for implementing an upper bridge circuit and the other two are used for implementing a lower bridge circuit. In addition, each power transistor may utilize its gate lead-out portion and source lead-out portion to connect to corresponding points of the half-bridge power module.

As shown in Fig. 10A, the power module 1000 may comprise a substrate 1010 and a semiconductor package 1020 manufactured according to the above process. Fig. 10B illustrates details of front arrangement of the semiconductor package 1020. According to Fig. 10B, the gates of the two power transistors for the upper bridge circuit are configured to electrically connect with the gate lead-out portion 1021, and the sources of two power transistors for the upper bridge circuit are configured to electrically connect with the source lead-out portion 1022. Correspondingly, the gates of the two power transistors for the lower bridge circuit are configured to electrically connect with the gate lead-out portion 1026, and the sources of two power transistors for the lower bridge circuit are configured to electrically connect with the source lead-out portion 1025. Besides, a connection region 1023 is formed to expose from the front of the semiconductor package 1020 and electrically connect with two power transistors for upper bridge circuit. The connection region 1023 also comprises a connecting strip running from the front to the back of the semiconductor package 1020. As shown in Fig. 10C, the connecting strip exposes from the back to form a connection region 1029. That is, the connection region 1029 is electrically connected with the sources of two power transistors of the upper bridge circuit. In addition, the drains 1028 of the four power transistors of the semiconductor package 1020 all expose from the back, and the rest of the front and the back of the semiconductor package 1020 may be disposed as an electrically insulated plastic package portion 1027.

Accordingly, as shown in Figs. 10A and 10D, the drains of the two power transistors for the upper bridge circuit in the power module 1000 are connected to a DC+ point 1042 of the power module 1000 via a drain point 1031, gates are electrically connected to the module gate detection point G via corresponding gate lines and a gate point 1032, and a source point 1033 is electrically connected to an AC point 1043 of the power module 1000 and the drains of two power transistors for lower bridge circuit in the power module 1000 via a connection region 1023, a connection region 1029 and a substrate 1010. Correspondingly, the sources of the two power transistors for the lower bridge circuit and the source point 1034 connected thereto are both connected to the DC- point 1041 of the power module 1000 via a conductive clip 1050, the gates are electrically connected to the module gate detection point G via corresponding gate lines and a gate point 1035; and the drains are connected to an AC point 1043 of the half-bridge power module via a drain point 1036. It is to be appreciated that although the connection region 1023 in Fig. 10A exposes from the upper surface as illustrated, this setting may also be substituted with coverage by insulating materials in accordance with specific design needs.

Through the above embodiments, the half-bridge power module may be assembled using one semiconductor package according to the present disclosure, the conductive paths of the sources of every two power transistors are made to have substantially the same length, and the conductive paths of the gates of every two power transistors are made to have substantially the same length. Therefore, crosstalk or other problems resulted from different electrical parameters may be avoided as much as possible.

In summary, the present disclosure re-designs the electrical connection mode of the semiconductor package containing a plurality of power transistors in parallel. Specifically, the present disclosure utilizes multi-level electrical connection layers, such that the gates and the sources of the respective power transistors may be electrically connected to the module gate detection point G and the module KS detection point outside the semiconductor package respectively through the electrical connection layers along the substantially same path. In this way, the present disclosure avoids differences in the length of paths from corresponding terminals of each power transistor to the respective points, such that parasitic capacitance and parasitic inductance from the sources of respective power transistors to the module KS detection point among other electrical parameters are substantially the same. Therefore, the KS voltage values measured at the module KS detection point may accurately reflect the source voltage values of the respective power transistors in real time. Moreover, the control signals received by the gates of the respective power transistors from the drive module also have the consistent waveform.

The present disclosure encompasses the following examples.

Example 1: A semiconductor package, comprising:
a chip level having a first side and a second side opposite to the first side, the chip level comprising a plurality of power transistors and each power transistor being provided with a source and a gate at the first side;
a first conductive level positioned on the first side and comprising a gate connection portion electrically connected with the gate and a source connection portion electrically connected with the source; and
a second conductive level comprising a gate lead-out portion electrically connected with the gate connection portion and a source lead-out portion electrically connected with the source connection portion, the first conductive level being positioned between the second conductive level and the chip level.

Example 2: The semiconductor package of example 1, further comprising:
a heat sink level comprising a plurality of heat sinks, each heat sink contacting a corresponding power transistor of the plurality of power transistors and the chip level being positioned between the heat sink level and the first conductive level.

Example 3: The semiconductor package of example 1, wherein each of the power transistors comprises:
a power transistor body at least having a gate region and a source region;
an insulating layer arranged on the power transistor body, a plurality of through holes being formed over the gate region and the source region; and
a conductive piece which fills the plurality of through holes, such that the gate region is electrically connected to the gate connection portion of the first conductive level and the source region is electrically connected to the source connection portion of the first conductive level.

Example 4: The semiconductor package of example 1, wherein the gate connection portion comprises:
a connection body arranged at a geometric center of the plurality of power transistors and the gate lead-out portion being positioned on the connection body; and
a plurality of connection branches, each of the plurality of connection branches having one end connected to the connection body and the other end connected to gate of a corresponding power transistor of the plurality of power transistors.

Example 5: The semiconductor package of example 4, wherein the plurality of connection branches is formed such that conductive paths from gates of the plurality of power transistors to the connection body are consistent.

Example 6: The semiconductor package of example 3, wherein the source region has an area greater than that of the gate region, and the source connection portion has an area greater than or equal to that of the source region.

Example 7: The semiconductor package of example 1, wherein a number of the plurality of power transistors is four.

Example 8: The semiconductor package of example 1, wherein the first conductive level and the second conductive level are made of a material selected from at least one of:
copper;
silver;
aluminum; and
soldering tin.

Example 9: The semiconductor package of example 1,
wherein the plurality of power transistors comprise a first set of power transistors and a second set of power transistors, and the first conductive level comprises:
   a first gate connection portion electrically connected with a gate of the first set of power transistors;
   a first source connection portion electrically connected with a source of the first set of power transistors;
   a second gate connection portion electrically connected with a gate of the second set of power transistors;
   a second source connection portion electrically connected with a source of the second set of power transistors;
and wherein the second conductive level comprises:
   a first gate lead-out portion electrically connected with the first gate connection portion;
   a first source lead-out portion electrically connected with the first source connection portion;
   a second gate lead-out portion electrically connected with the second gate connection portion; and
   a second source lead-out portion electrically connected with the second source connection portion.

Example 10: The semiconductor package of example 9, further comprising:
an interconnect for electrically connecting the first source lead-out portion to a drain of the second set of power transistors.

Example 11: The semiconductor package of example 1, further comprising:
a power transistor connector positioned at a corresponding position of each power transistor of the plurality of power transistors, the power transistor connector comprising a plurality of through holes filled with a conductive piece, such that a gate of a power transistor is electrically connected to a corresponding gate connection portion of the first conductive level and a source of a power transistor is electrically connected to a corresponding source connection portion of the first conductive level.

Example 12: A method of forming a semiconductor package, comprising:
forming a chip level having a first side and a second side opposite to the first side and comprising a plurality of power transistors, each power transistor being provided with a source and a gate at the first side;
forming, on the first side of the chip level, a first conductive level, the first conductive level comprising a gate connection portion electrically connected with the gate and a source connection portion electrically connected with the source; and
forming, on a side of the first conductive level away from the chip level, a second conductive level, the second conductive level comprising a gate lead-out portion electrically connected with the gate connection portion and a source lead-out portion electrically connected with the source connection portion.

Example 13: The method of example 12, further comprising:
forming, on the second side of the chip level, a heat sink level, the heat sink level comprising a plurality of heat sinks, each heat sink contacting a corresponding power transistor of the plurality of power transistors.

Example 14: The method of example 12, wherein forming the chip level at least comprises:
forming a power transistor body at least having a gate region and a source region;
forming an insulating layer over the power transistor body;
forming, in the insulating layer, a plurality of through holes respectively corresponding to the gate region and the source region; and
filling the plurality of through holes with a conductive piece, such that the gate region is electrically connected to the gate connection portion of the first conductive level and the source region is electrically connected to the source connection portion of the first conductive level.

Example 15: The method of example 12, wherein the gate connection portion is formed to comprise:
a connection body arranged at a geometric center of the plurality of power transistors and the gate lead-out portion being positioned on the connection body; and
a plurality of connection branches, each of the plurality of connection branches having one end connected to the connection body and the other end connected to gate of a corresponding power transistor of the plurality of power transistors.

Example 16: The method of example 14, wherein the source region has an area greater than that of the gate region, and the source connection portion has an area greater than or equal to that of the source region.

Example 17: The method of example 13, wherein forming the heat sink level comprises:
sputtering the second side of the chip level using TiCu;
forming, at a predetermined position of the sputtered second side, a corresponding heat sink of the plurality of heat sinks; and
removing the TiCu by etching.

Example 18: The method of example 14, wherein filling the plurality of through holes with the conductive piece comprises:
sputtering at least the plurality of through holes using TiCu;
filling the conductive piece into the plurality of sputtered through holes; and
removing the TiCu by etching.

Example 19: A power module, comprising:
a substrate at least arranged with a gate wiring board and a source wiring board; and
the semiconductor package according to any of claims 1 to 11, the semiconductor package being positioned on the substrate, and the gate lead-out portion being electrically connected to the gate wiring board via a gate line and the source lead-out portion being electrically connected to the source wiring board via a source line.

Example 20: The power module of example 19, wherein the gate wiring board and the source wiring board are connected to a drive module respectively via a corresponding part of a lead frame.

Details and embodiments may be modified or even significantly changed with respect to the contents already described by way of examples without deviating from the protection scope.

Claims are parts of the technical teaching provided for the embodiments in the text.

The protection scope is subject to the attached claims.

## Claims

1. A semiconductor package, comprising:
a chip level having a first side and a second side opposite to the first side, the chip level comprising a plurality of power transistors and each power transistor being provided with a source and a gate at the first side;
a first conductive level positioned on the first side and comprising a gate connection portion electrically connected with the gate and a source connection portion electrically connected with the source; and
a second conductive level comprising a gate lead-out portion electrically connected with the gate connection portion and a source lead-out portion electrically connected with the source connection portion, the first conductive level being positioned between the second conductive level and the chip level.

2. A method of forming a semiconductor package, comprising:
forming a chip level having a first side and a second side opposite to the first side and comprising a plurality of power transistors, each power transistor being provided with a source and a gate at the first side;
forming, on the first side of the chip level, a first conductive level, the first conductive level comprising a gate connection portion electrically connected with the gate and a source connection portion electrically connected with the source; and
forming, on a side of the first conductive level away from the chip level, a second conductive level, the second conductive level comprising a gate lead-out portion electrically connected with the gate connection portion and a source lead-out portion electrically connected with the source connection portion.

3. The semiconductor package of claim 1 further comprising, or the method of claim 2 further comprising forming, on the second side of the chip level:
a heat sink level comprising a plurality of heat sinks, each heat sink contacting a corresponding power transistor of the plurality of power transistors and the chip level being positioned between the heat sink level and the first conductive level.

4. The semiconductor package of claim 1 or 3, or the method of claim 2 or 3, wherein each of the power transistors comprises or forming the chip level at least comprises forming:
a power transistor body at least having a gate region and a source region;
an insulating layer arranged on the power transistor body, a plurality of through holes being formed, in the insulating layer, over the gate region and the source region; and
a conductive piece which fills the plurality of through holes, such that the gate region is electrically connected to the gate connection portion of the first conductive level and the source region is electrically connected to the source connection portion of the first conductive level.

5. The semiconductor package of claims 1, 3 or 4, or the method of any of claims 2 to 4, wherein the gate connection portion comprises or is formed to comprise:
a connection body arranged at a geometric center of the plurality of power transistors and the gate lead-out portion being positioned on the connection body; and
a plurality of connection branches, each of the plurality of connection branches having one end connected to the connection body and the other end connected to gate of a corresponding power transistor of the plurality of power transistors.

6. The semiconductor package or the method of claim 5, wherein the plurality of connection branches is formed such that conductive paths from gates of the plurality of power transistors to the connection body are consistent.

7. The semiconductor package or the method of any of claims 3 to 6, wherein the source region has an area greater than that of the gate region, and the source connection portion has an area greater than or equal to that of the source region.

8. The semiconductor package of any of claims 1, 3 to 7, or the method of any of claims 2 to 7, wherein a number of the plurality of power transistors is four.

9. The semiconductor package of any of claims 1, 3 to 8, or the method of any of claims 2 to 8, wherein the first conductive level and the second conductive level are made of a material selected from at least one of:
copper;
silver;
aluminum; and
soldering tin.

10. The semiconductor package of any of claims 1, 3 to 9, or the method of any of claims 2 to 9,
wherein the plurality of power transistors comprise a first set of power transistors and a second set of power transistors, and the first conductive level comprises:
a first gate connection portion electrically connected with a gate of the first set of power transistors;
a first source connection portion electrically connected with a source of the first set of power transistors;
a second gate connection portion electrically connected with a gate of the second set of power transistors;
a second source connection portion electrically connected with a source of the second set of power transistors;
and wherein the second conductive level comprises:
a first gate lead-out portion electrically connected with the first gate connection portion;
a first source lead-out portion electrically connected with the first source connection portion;
a second gate lead-out portion electrically connected with the second gate connection portion; and
a second source lead-out portion electrically connected with the second source connection portion.

11. The semiconductor package or the method of claim 10, further comprising:
an interconnect for electrically connecting the first source lead-out portion to a drain of the second set of power transistors.

12. The semiconductor package of any of claims 1, 3 to 11, or the method of any of claims 2 to 11, further comprising:
a power transistor connector positioned at a corresponding position of each power transistor of the plurality of power transistors, the power transistor connector comprising a plurality of through holes filled with a conductive piece, such that a gate of a power transistor is electrically connected to a corresponding gate connection portion of the first conductive level and a source of a power transistor is electrically connected to a corresponding source connection portion of the first conductive level.

13. The method of any of claims 2 to 12, wherein forming the heat sink level comprises:
sputtering the second side of the chip level using TiCu;
forming, at a predetermined position of the sputtered second side, a corresponding heat sink of the plurality of heat sinks; and
removing the TiCu by etching.

14. The method of any of claims 4 to 13, wherein filling the plurality of through holes with the conductive piece comprises:
sputtering at least the plurality of through holes using TiCu;
filling the conductive piece into the plurality of sputtered through holes; and
removing the TiCu by etching.

15. A power module, comprising:
a substrate at least arranged with a gate wiring board and a source wiring board; and
the semiconductor package according to any of claims 1, 3 to 12, the semiconductor package being positioned on the substrate, and the gate lead-out portion being electrically connected to the gate wiring board via a gate line and the source lead-out portion being electrically connected to the source wiring board via a source line.

16. The power module of claim 15, wherein the gate wiring board and the source wiring board are connected to a drive module respectively via a corresponding part of a lead frame.
